# DEMANDE DE BREVET EUROPEEN

(11) **EP 4 243 061 A1**
(43) Date de publication de la demande: **13.09.2023**
(21) Numéro de dépôt: 23160299.6
(22) Date de dépôt: 06.03.2023
(51) Int. Cl.: H01L 21/768, H01L 29/78, H01L 23/532, H01L 23/528, H01L 23/535, H01L 29/786

(54) **TRANSISTOR MOS SUR STRUCTURE SOI**

(30) Priorité: 11.03.2022 FR 2202143
(71) Demandeur: STMICROELECTRONICS SA, 92120 Montrouge (FR); STMicroelectronics Crolles 2 SAS, 38920 Crolles (FR)
(72) Inventeur: CREMER, Sebastien, 38360 SASSENAGE (FR); MONSIEUR, Frederic, 38530 PONTCHARRA (FR); FLEURY, Alain, 73000 BARBERAZ (FR); HAENDLER, Sebastien, 38530 BARRAUX (FR)
(74) Mandataire: Cabinet Beaumont

(57) **Abrégé**

La présente description concerne un dispositif (2) comprenant une couche semiconductrice active (17) sur et en contact avec une couche isolante, le dispositif comprenant au moins un transistor (111) comprenant une région de source (19), une région de drain (21) et une région de corps (23) disposées dans la couche active (17), la région de corps (23) étant reliée à un via conducteur (41) traversant la couche isolante.

## Description

### Domaine technique

La présente description concerne de façon générale les composants électroniques, et, plus particulièrement, les transistors MOS (de l'anglais "Metal Oxide Semiconductor" - métal oxyde semiconducteur). Elle vise plus particulièrement un transistor MOS réalisé dans et sur une structure SOI (de l'anglais "Semiconductor On Insulator" - semiconducteur sur isolant).

### Technique antérieure

Diverses réalisations de transistors MOS intégrés dans et sur une structure SOI ont déjà été proposées. Les transistors MOS sur structure SOI présentent de nombreux avantages parmi lesquels une densité d'intégration élevée et des performances électriques élevées.

Il serait souhaitable de pallier au moins en partie certains inconvénients des réalisations connues de transistors MOS sur structure SOI.

### Résumé de l'invention

Pour cela, un mode de réalisation prévoit un dispositif comprenant une couche semiconductrice active sur et en contact avec une couche isolante, le dispositif comprenant au moins un transistor comprenant une région de source, une région de drain et une région de corps disposées dans la couche active, la région de corps étant reliée à un via conducteur traversant la couche isolante.

Selon un mode de réalisation, la couche isolante est disposée sur et en contact avec un substrat semiconducteur, le via conducteur étant adapté à connecter électriquement la région de corps au substrat semiconducteur.

Selon un mode de réalisation, le dispositif comprend un plot de contact de corps, connecté à la région de corps, le plot de contact étant connecté au via conducteur par une piste métallique d'un réseau d'interconnexion du dispositif.

Selon un mode de réalisation, ladite piste métallique est entièrement disposée dans le plus bas niveau de pistes métalliques du réseau d'interconnexion.

Selon un mode de réalisation, le via conducteur est isolé latéralement de la couche active.

Selon un mode de réalisation, le via conducteur est en un matériau métallique, par exemple en tungstène.

Selon un mode de réalisation, le transistor comprend un empilement d'un isolant de grille et d'une grille conductrice surmontant la région de corps entre les régions de source et de drain.

Selon un mode de réalisation, le transistor est un transistor PDSOI.

Selon un mode de réalisation, le dispositif comprend une pluralité de transistors disposés dans et sur la couche active, le dispositif comprenant, pour chaque transistor, un via conducteur spécifique par transistor, connecté à la région de corps du transistor et traversant la couche isolante.

Selon un mode de réalisation, le dispositif comprend une pluralité de transistors formés dans et sur la couche active, le via conducteur étant connecté à des régions de corps de plusieurs transistors du dispositif.

Un autre mode de réalisation prévoit un procédé de fabrication d'un dispositif comprenant une couche semiconductrice active sur et en contact avec une couche isolante, le dispositif comprenant un transistor comprenant une région de source, une région de drain et une région de corps formées dans la couche active, le procédé comprenant la formation d'un via conducteur connecté à la région de corps et traversant la couche isolante.

Selon un mode de réalisation, le plot de contact de corps et le via conducteur sont formés simultanément lors d'une même étape de dépôt métallique.

Selon un mode de réalisation, le transistor est entouré par une tranchée isolante, le via conducteur étant formé dans la tranchée isolante.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente, par une vue de dessus, partielle et schématique, un exemple de dispositif comportant un transistor MOS sur structure SOI ;
la figure 1B représente une première vue en coupe, du dispositif de la figure 1A, selon le plan de coupe BB de la figure 1A ;
la figure 1C représente une deuxième vue en coupe du dispositif de la figure 1A, selon le plan de coupe CC de la figure 1A ;
la figure 1D représente une troisième vue en coupe du dispositif de la figure 1A, selon le plan de coupe DD de la figure 1A ;
la figure 2A représente, par une vue de dessus, partielle et schématique, un exemple de dispositif comprenant un transistor MOS sur structure SOI selon un mode de réalisation ; et
la figure 2B représente, par une vue en coupe, du dispositif illustré en figure 2A.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les procédés de fabrication des transistors MOS décrits n'ont pas été détaillés. En outre les diverses applications que peuvent avoir les transistors MOS décrits n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe des figures.

Sauf précision contraire, les expressions "environ", "approximativement", "sensiblement", et "de l'ordre de" signifient à 10 % près, de préférence à 5 % près.

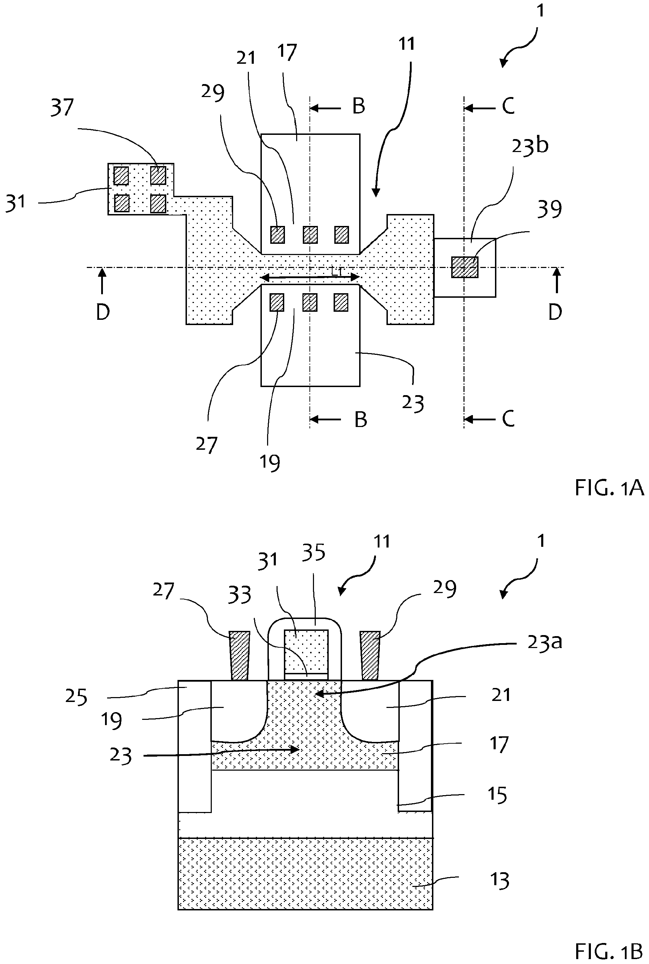

La figure 1A représente, par une vue de dessus, partielle et schématique, un exemple de dispositif 1 comportant un transistor MOS 11.

La figure 1B représente une première vue en coupe du dispositif 1 de la figure 1A, la figure 1B étant une vue selon le plan de coupe BB de la figure 1A.

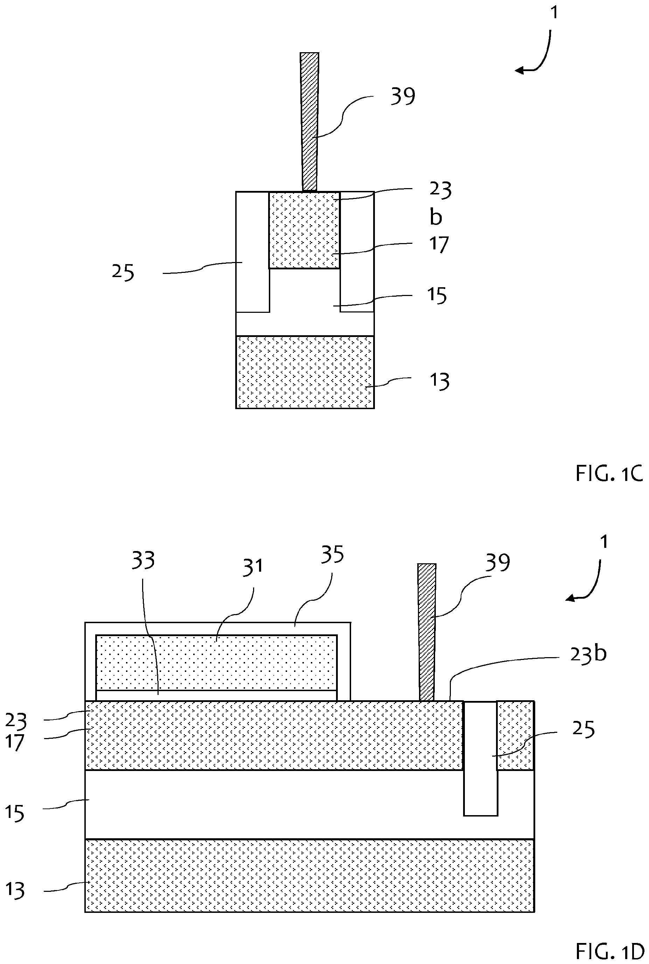

La figure 1C représente une deuxième vue en coupe du dispositif 1 de la figure 1A, la figure 1C étant une vue selon le plan de coupe CC de la figure 1A.

La figure 1D représente une troisième vue en coupe du dispositif 1 de la figure 1A, la figure 1D étant une vue selon le plan de coupe DD de la figure 1A.

Le transistor 11 est formé dans et sur une structure SOI comprenant un substrat de support 13 en un matériau semiconducteur, par exemple en silicium, surmonté d'une couche isolante enterrée 15, par exemple en dioxyde de silicium (SiO₂), elle-même surmontée d'une couche semiconductrice active 17, par exemple en silicium, par exemple en silicium monocristallin.

A titre d'exemple, le substrat 13 a une épaisseur comprise entre 200 µm et 800 µm, par exemple entre 500 µm et 800 µm, par exemple de l'ordre de 775 µm. A titre d'exemple, le substrat 13 est un substrat fortement résistif, par exemple de résistivité comprise ente 1 kΩ.cm et 10 kΩ.cm, par exemple, entre 2 kΩ.cm et 8 kΩ.cm. Le substrat 13 est par exemple dopé de type P. A titre d'exemple, le substrat 13 est dopé avec de atomes de bore. A titre d'exemple, le niveau de dopage du substrat 13 est compris entre 10¹² at/cm³ et 10¹³ at/cm³.

La couche isolante enterrée 15 a par exemple une épaisseur comprise entre 100 nm et 400 nm, par exemple entre 100 nm et 250 nm, par exemple de l'ordre de 200 nm.

La couche semiconductrice active 17 a par exemple une épaisseur comprise entre 30 nm et 500 nm, par exemple entre 50 nm et 200 nm, par exemple de l'ordre de 75 nm.

A titre d'exemple, la couche isolante enterrée 15 est formée sur et en contact avec le substrat semiconducteur 13 de sorte que la face inférieure de la couche isolante enterrée 15 soit en contact avec la face supérieure du substrat semiconducteur 13. La couche semiconductrice active 17 est par exemple formée sur et en contact avec la couche isolante enterrée 15 de sorte que la face inférieure de la couche semiconductrice active 17 soit en contact avec la face supérieure de la couche isolante enterrée 15.

Sur les figures 1A, 1B, 1C et 1D, un unique transistor 11 a été représenté. Toutefois, en pratique, le dispositif 1 peut comprendre une pluralité de transistors 11, par exemple identiques ou similaires intégrés dans et sur la structure SOI.

Le transistor 11 comprend une région de source 19 et une région de drain 21 formées dans la couche semiconductrice active 17. Les régions de source 19 et de drain 21 sont séparées latéralement l'une de l'autre par une région de corps 23 (body). Une partie supérieure 23a de la région de corps 23 constitue la région de formation de canal du transistor 11. A titre d'exemple, les régions de source 19, de drain 21 et de corps 23 affleurent la face supérieure de la couche semiconductrice active 17.

Le transistor 11 est, par exemple, un transistor MOS à canal P (PMOS) c'est-à-dire un transistor dont les régions de source 19 et de drain 21 sont dopées de type P, par exemple dopées d'atomes de bore, alors que la région de corps 23 est dopée de type N, par exemple dopée d'atomes d'arsenic ou de phosphore. Les modes de réalisation décrits ne se limitent toutefois pas à ce cas particulier et peuvent s'appliquer aussi à des transistors MOS à canal N (NMOS). A titre d'exemple, le transistor 11 est un transistor PDSOI (de l'anglais "Partially Depleted Semiconductor On Insulator" - semiconducteur sur isolant partiellement déplété), c'est-à-dire un transistor dans lequel, en l'absence de polarisation, la zone de corps est partiellement déplétée (par contraste avec les transistors FDSOI - de l'anglais "Fully Depleted Semiconductor On Insulator" - semiconducteur sur isolant totalement déplété, dans lesquels, en l'absence de polarisation, la zone de corps est entièrement déplétée).

Le transistor 11 comprend un ou plusieurs plots de contact 27 surmontant la région de source 19 et connectés électriquement à la région de source 19, et un ou plusieurs plots de contact 29 surmontant la région de drain 21 et connectés électriquement à la région de drain 21. Dans l'exemple représenté, les plots de contact de source 27 sont en contact, par leurs faces inférieures, avec la face supérieure de la région de source 19 et les plots de contact de drain 29 sont en contact, par leurs faces inférieures, avec la face supérieure de la région de drain 21. Les plots de contact 27, 29 permettent le contact électrique entre les régions de source 19 et de drain 21 du transistor 11 et d'autres composants par l'intermédiaire d'un réseau d'interconnexion non représenté en figures 1A, 1B, 1C et 1D. En figure 1A, trois plots de contact 27 et trois plots de contact 29 ont été représentés, en pratique, le nombre de plots de contact de chaque type peut être différent de trois. Les plots de contacts 27, 29 sont, par exemple, en un matériau métallique, par exemple, en tungstène. A titre d'exemple, la région de source 19 et la région de drain 21 sont plus fortement dopées localement au contact des plots 27 et 29 afin d'optimiser le contact électrique entre les régions 19, 21 et, respectivement, les plots de contact 27 et 29.

Les régions de source 19 et de drain 21 s'étendent, par exemple, orthogonalement au plan de coupe de la figure 1B, le long du plan de coupe DD de la figure 1A sur une première largeur L1.

Le transistor 11 comprend, en outre, une grille conductrice 31 située au-dessus de la région de formation de canal 23a, en vis-à-vis de la région de formation canal 23a. La grille 31 est séparée de la région de formation de canal 23a par une couche isolante 33 dite isolant de grille. A titre d'exemple, l'isolant de grille est en dioxyde de silicium (SiO₂) et a, par exemple, une épaisseur comprise entre 1 nm et 10 nm, par exemple, de l'ordre de 5 nm. L'isolant de grille 33 est par exemple en contact, par sa face inférieure, avec la face supérieure de la région de formation de canal 23a, et, par sa face supérieure, avec la face inférieure de la grille conductrice 31. La grille 31 est, par exemple, recouverte, du côté de sa face supérieure, par une couche isolante de passivation 35, par exemple en dioxyde de silicium. Des espaceurs isolants peuvent en outre revêtir les flancs de la grille 31 et les flancs de l'isolant de grille 33. Les espaceurs isolants sont, par exemple, en nitrure de silicium (Si₃N₄) et/ou en dioxyde de silicium (SiO₂). La grille 31 est, par exemple, en silicium polycristallin dopé.

Dans l'exemple représenté, la grille 31, l'isolant de grille 33 et la couche de passivation 35 se prolongent latéralement au-delà de la région de formation de canal 23a. A titre d'exemple, la grille 31 est connectée à un ou d'autres composants par l'intermédiaire de plots de contacts 37 aussi appelés contacts de grille, et d'un réseau d'interconnexion non représenté. A titre d'exemple, les contacts de grille 37 sont déportés en dehors du vis-à-vis de la région de formation de canal 23a. En figure 1A, quatre contacts de grille 37 ont été représentés. Toutefois, en pratique, le nombre de contacts de grille 37 peut être différent de quatre. A titre d'exemple, les contacts de grille 37 sont métalliques, par exemple en le même matériau que les plots de contact de source 27 et de drain 29, par exemple en tungstène. Dans l'exemple représenté, les plots de contact de grille 37 sont en contact, par leurs faces inférieures, avec la face supérieure de la grille 31.

Dans cet exemple, la région de corps 23 se prolonge latéralement, au-delà des régions de source 19 et de drain 21, par une région de reprise de contact de corps 23b affleurant au niveau de la face supérieure de la couche active 17. La région de reprise de contact de corps 23b n'est pas recouverte par la grille 31. Le transistor 11 des figures 1A, 1B, 1C et 1D comprend, en contact avec la région de reprise de contact de corps 23b, un ou plusieurs plots de contact 39 appelés plots de contact de corps. Dans l'exemple des figures 1A, 1B, 1C et 1D, le transistor 11 comprend un unique plot de contact de corps 39. Le plot de contact de corps 39 est, par exemple, sur et en contact, mécaniquement et électriquement, avec la région de reprise de contact de corps 23b. A titre d'exemple, la région de reprise de contact de corps 23b est plus fortement dopée localement au voisinage du plot de contact 39 afin d'optimiser le contact électrique entre la région 23 et le plot de contact 39. Le plot de contact 39 permet le contact électrique entre la région de corps 23 du transistor 11 et d'autres composants par l'intermédiaire d'un réseau d'interconnexion non représenté en figures 1A, 1B, 1C et 1D.

Le plot de contact 39 est, de préférence, en un matériau métallique, par exemple identique au matériau des plots de contact 27, 29. Le plot de contact 39 est, par exemple en tungstène.

Dans cet exemple, le transistor 11 est entouré latéralement par une tranchée isolante 25, par exemple de type STI (de l'anglais "Shallow Trench Isolation" - tranchée d'isolation peu profonde). La tranchée isolante 25 forme ainsi un anneau autour du transistor 11. La tranchée isolante 25 s'étend, par exemple, verticalement, à partir de la face supérieure de la couche semiconductrice active 17, à travers toute l'épaisseur de la couche semiconductrice active 17 de façon à atteindre la couche isolante enterrée 15. Dans l'exemple représenté, la tranchée isolante 25 débouche dans la couche isolante enterrée 15. A titre de variante (non représentée), la tranchée isolante 25 peut traverser entièrement la couche isolante enterrée 15 et tout ou partie de l'épaisseur du substrat 13. A titre d'exemple, les régions de source 19 et de drain 21 sont en contact, latéralement, avec un flanc de la tranchée 25. La tranchée isolante 25 permet d'isoler électriquement le transistor 11 d'autres composants (non visibles sur la figure) du dispositif.

Le transistor 11 est, par exemple, recouvert par un réseau d'interconnexion non représenté en figures 1A, 1B, 1C et 1D, permettant de connecter le transistor 11, par ses plots de contact 27, 29, 37 et 39, à d'autres composants. Le réseau d'interconnexion comprend, par exemple, plusieurs niveaux de métallisation empilés, séparés deux à deux par des niveaux isolants eux-mêmes traversés par des vias métalliques.

La réalisation du réseau d'interconnexion peut comprendre des étapes de gravure plasma et de planarisation mécano-chimique pouvant générer des charges électriques parasites qui sont susceptibles d'être piégées aux interfaces entre la région de corps 23 et les couches isolantes 15 et 25. Plus particulièrement, les plasmas permettant de réaliser les gravures sont générés à partir de tension électriques importantes. Le procédé de gravure est ainsi mis en oeuvre dans des conditions de champs électriques importants ce qui est susceptible de provoquer l'introduction de charges parasites dans la région de corps 23. En outre, les procédés de planarisation mécano-chimique peuvent générer des charges parasites par des mécanismes type électro-friction. L'accumulation de ces charges parasites modifie de façon indésirable les propriétés électriques du transistor 11. Ce problème d'injection de charges parasites aux interfaces avec les couches 15 et/ou 25 se pose tout particulièrement lors de la réalisation du ou des niveaux de métallisation supérieurs du réseau d'interconnexion, généralement relativement épais, par exemple d'épaisseur comprise entre 1 µm et 10 µm, par exemple de l'ordre de 3 µm à 6 µm.

Selon un aspect d'un mode de réalisation, on prévoit de former, avant la réalisation des niveaux de métallisation supérieurs du réseau d'interconnexion du dispositif, un chemin de conduction entre la région de corps 23 du transistor 11 et le substrat semiconducteur 13 de la structure SOI, de façon à créer un chemin d'évacuation des charges parasites et éviter leur piégeage aux interfaces avec les couches 15 et 25 délimitant la région de corps 23.

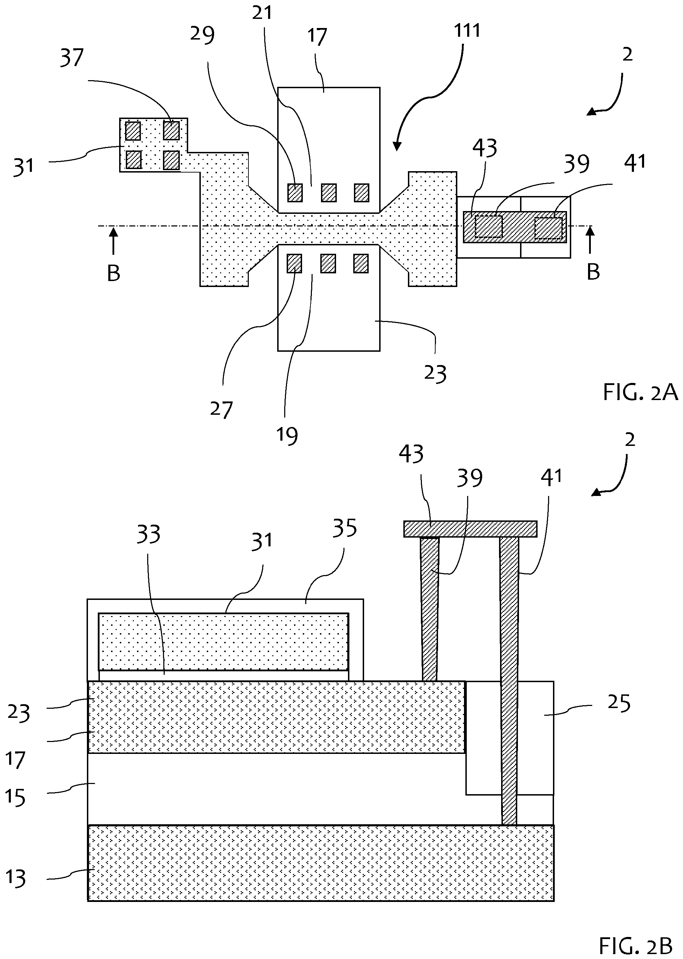

La figure 2A représente, par une vue de dessus, partielle et schématique, un exemple de dispositif 2 comprenant un transistor MOS 111 selon un mode de réalisation.

La figure 2B représente une vue en coupe du dispositif 2 de la figure 2A, la figure 2B étant une vue en coupe selon le plan de coupe BB de la figure 2A.

Le dispositif 2 des figures 2A et 2B comprend des éléments communs avec le dispositif 1 des figures 1A, 1B, 1C et 1D. Par exemple, le transistor 111 est similaire au transistor 11 illustré en figures 1A, 1B, 1C et 1D. Par souci de simplification, ces éléments ne seront pas détaillés à nouveau ci-après.

Le dispositif 2 des figures 2A et 2B diffère du dispositif 1 des figures 1A, 1B, 1C et 1D essentiellement en ce que, dans le mode de réalisation des figures 2A et 2B, le dispositif 2 comprend un via conducteur 41 ou VTB (de l'anglais "Via Through Box") s'étendant verticalement à travers la couche active 17 (plus particulièrement, dans l'exemple représenté, à travers une région isolante 25 traversant la couche active 17) et la couche isolante enterrée 15 et débouchant dans ou sur et en contact avec la face supérieure du substrat semiconducteur 13.

Dans le mode de réalisation illustré en figures 2A et 2B, la région de corps 23 du transistor 11 est reliée, de préférence connectée, au substrat semiconducteur 13 par le via conducteur 41. Plus particulièrement, dans cet exemple, la région de corps 23 et le substrat semiconducteur 13 sont reliés, de préférence connectée, électriquement, par l'intermédiaire du plot de contact 39 et du via conducteur 41. Le plot de contact 39 et le via conducteur 41 sont reliés, de préférence connectés, l'un à l'autre, par exemple directement, par une piste métallique 43, par exemple en cuivre. A titre d'exemple, la piste métallique 43 est en contact, mécaniquement et électriquement, par sa face inférieure, avec la face supérieure du plot de contact de corps 39 et avec la face supérieure du via conducteur 41. La piste métallique 43 est par exemple une piste du premier niveau de métallisation M1 (correspondant au plus bas niveau) du réseau d'interconnexion formé du côté de la face supérieure du dispositif.

Le via conducteur 41 est par exemple isolé latéralement de la couche active 17. A titre d'exemple, le via conducteur 41 est formé en vis à vis d'une partie de la structure SOI dans laquelle la couche active 17 a préalablement été retirée et remplacée par un matériau diélectrique, par exemple du dioxyde de silicium (par exemple en même temps que sont formées les tranchées isolantes 25). A titre d'exemple, le via conducteur 41 a une largeur supérieure à la largeur du plot de contact 39. Le via conducteur 41 a, par exemple, une largeur comprise entre 10 nm et 300 nm, par exemple comprise entre 50 nm et 200 nm, par exemple de l'ordre de 150 nm. Le via conducteur 41 est, par exemple en un matériau métallique, par exemple identique au matériau des plots de contact 27, 29, 37 et/ou 39, par exemple en tungstène.

Le via conducteur 41 est, par exemple, situé au voisinage du plot de contact de corps 39.

A titre d'exemple, le via conducteur 41 est formé dans la région d'isolation 25 (comme illustré en figures 2A et 2B) délimitant latéralement le transistor 111.

Alors que plusieurs dispositifs 2 sont, généralement, réalisés en même temps sur une même plaque semiconductrice, les vias conducteurs 41 peuvent être mutualisés. C'est-à-dire qu'un via conducteur 41 peut être commun à plusieurs transistors 111, par exemple, voisins. En d'autres termes, un même via conducteur 41 peut permettre l'évacuation de charges accumulées dans et autour de plusieurs transistors 111, par exemple voisins. Dans ce mode de réalisation, les plots de contact de corps 39 desdits transistors sont connectés électriquement ensemble, par exemple par des pistes métalliques du ou des niveaux inférieurs du réseau d'interconnexion. A titre de variante, le dispositif peut comprendre un via conducteur 41 spécifique par transistor.

Le via conducteur 41 est, par exemple, formé entre une étape de formation d'un diélectrique pré-métallique (non détaillé sur les figures) sur la face supérieure de la couche active 17 et de la grille 31 et des étapes de formation des niveaux de métallisation du réseau d'interconnexion du dispositif. A titre d'exemple, la formation du via conducteur 41 comprend une étape de formation d'une ouverture à travers la tranchée isolante 25. En variante, la formation du via conducteur 41 comprend une étape de formation d'une ouverture à travers le diélectrique pré-métallique, la couche active 17 et éventuellement la couche isolante enterrée 15. L'étape de formation de l'ouverture est suivie d'une étape de remplissage de l'ouverture par le matériau du via conducteur 41.

La formation du plot de contact de corps 39 comprend par exemple une étape de formation d'une ouverture à travers le diélectrique pré-métallique, suivie d'une étape de remplissage de l'ouverture par le matériau du plot 39.

L'ouverture du plot de contact de corps 39 et l'ouverture du via conducteur 41 sont par exemple réalisées successivement lors d'étapes de photolithographie distinctes. L'ouverture du via conducteur 41 est, par exemple, réalisée avant l'ouverture du plot de contact 39. Le remplissage du via conducteur 41 et le remplissage du plot de contact 39, avec un matériau conducteur sont par exemple réalisés simultanément après les étapes de formation des ouvertures, en une seule et même étape de dépôt métallique suivie, par exemple, d'une étape de planarisation mécano-chimique.

La piste conductrice 43 peut ensuite être formée sur et en contact avec la face supérieure du via 41 et du plot de contact 39.

A ce stade du procédé, la région de corps 23 du transistor 111 est connectée électriquement au substrat semiconducteur 13 par l'intermédiaire du via 41. Les niveaux de métallisation supérieurs de l'empilement d'interconnexion peuvent ensuite être formés.

Un avantage du mode de réalisation décrit est que le via conducteur 41 permet l'évacuation des charges parasites générées, dans la région de corps 23 du transistor, lors des étapes de fabrication des niveaux de métallisation supérieurs du réseau d'interconnexion du dispositif. Le via conducteur 41 permet, en outre, l'évacuation de charges créées lors d'autres étapes du procédé de fabrication comme des étapes de sciage, de meulage, etc. Ceci permet de limiter très significativement le piégeage des charges parasites aux interfaces entre la région de corps 23 du transistor 111 et les couches isolantes 15 et/ou 25.

En pratique, pendant le procédé de fabrication du dispositif, le substrat 13 peut être connecté électriquement à un potentiel de référence, par exemple la masse, ou en contact avec un support métallique conducteur formant un plan de masse.

Un autre avantage du mode de réalisation décrit est que le via conducteur 41 peut être réalisé en dehors de la partie active du transistor, la taille d'un transistor n'est donc pas augmentée. De plus, la fabrication du via conducteur 41 est compatible avec les procédés de fabrication usuels des transistors.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description.

Enfin, la mise en oeuvre pratique des modes de réalisation et variantes décrits est à la portée de la personne du métier à partir des indications fonctionnelles données ci-dessus.

## Revendications

1. Dispositif (2) comprenant une couche semiconductrice active (17) sur et en contact avec une couche isolante (15), le dispositif comprenant au moins un transistor (111) comprenant une région de source (19), une région de drain (21) et une région de corps (23) disposées dans la couche active (17), la région de corps (23) étant reliée à un via conducteur (41) traversant la couche isolante (15),dans lequel la couche isolante (15) est disposée sur et en contact avec un substrat semiconducteur (13), le via conducteur (41) connectant électriquement la région de corps (23) au substrat semiconducteur (13).

2. Dispositif (2) selon la revendication 1, comprenant un plot de contact de corps (39), connecté à la région de corps (23), le plot de contact (39) étant connecté au via conducteur (41) par une piste métallique (43) d'un réseau d'interconnexion du dispositif.

3. Dispositif (2) selon la revendication 2, dans lequel ladite piste métallique (43) est entièrement disposée dans le plus bas niveau de pistes métalliques du réseau d'interconnexion.

4. Dispositif (2) selon l'une quelconque des revendications 1 à 3, dans lequel le via conducteur (41) est isolé latéralement de la couche active (17).

5. Dispositif (2) selon l'une quelconque des revendications 1 à 4, dans lequel le via conducteur (41) est en un matériau métallique, par exemple en tungstène.

6. Dispositif (2) selon l'une quelconque des revendications 1 à 5, dans lequel le transistor comprend un empilement d'un isolant de grille (33) et d'une grille conductrice (31) surmontant la région de corps (23) entre les régions de source (19) et de drain (21).

7. Dispositif (2) selon l'une quelconque des revendications 1 à 6, dans lequel le transistor (111) est un transistor PDSOI.

8. Dispositif (2) selon l'une quelconque des revendications 1 à 7, comprenant une pluralité de transistors (111) disposés dans et sur la couche active (17), le dispositif comprenant, pour chaque transistor (111), un via conducteur (41) spécifique par transistor (111), connecté à la région de corps (23) du transistor et traversant la couche isolante (15).

9. Dispositif (2) selon l'une quelconque des revendications 1 à 7, comprenant une pluralité de transistors (111) formés dans et sur la couche active (17), le via conducteur (41) étant connecté à des régions de corps (23) de plusieurs transistors du dispositif (2).

10. Procédé de fabrication d'un dispositif (2) comprenant une couche semiconductrice active (17) sur et en contact avec une couche isolante (15), le dispositif comprenant un transistor (111) comprenant une région de source (19), une région de drain (21) et une région de corps (23) formées dans la couche active (17), le procédé comprenant la formation d'un via conducteur (41) connecté à la région de corps (23) et traversant la couche isolante (15).

11. Procédé selon la revendication 10 dans son rattachement à la revendication 3, dans lequel le plot de contact de corps (39) et le via conducteur (41) sont formés simultanément lors d'une même étape de dépôt métallique.

12. Procédé selon la revendication 10 ou 11, dans lequel le transistor est entouré par une tranchée isolante (25), le via conducteur (41) étant formé dans la tranchée isolante (25).
